# EUROPEAN PATENT APPLICATION

(11) **EP 1 109 434 A2**
(43) Date of publication of application: **20.06.2001**
(21) Application number: 00311097.0
(22) Date of filing: 13.12.2000
(51) Int. Cl.: H05K 9/00

(54) **Transparent electromagnetic radiation shield material and method of producing the same**

(30) Priority: 17.12.1999 JP 37670099
(71) Applicant: NISSHINBO INDUSTRIES, INC., Tokyo 103 (JP)
(72) Inventor: Marutsuka, Toshinori, Chiba-shi, Chiba (JP)
(74) Representative: Stuart, Ian Alexander

(57) **Abstract**

A transparent electromagnetic radiation shield material includes a transparent base material, a hydrophobic transparent resin coating containing reduced metal particles laminated on the base material, and a mesh-like electroless plating layer laminated on the coating to form in the coating under the plating layer a blackened portion of mesh-like pattern identical to and aligned with that of the plating layer. A method of producing a transparent electromagnetic radiation shield material includes a step of laminating a hydrophobic transparent resin coating containing reduced metal particles on a transparent base material, a step of treating the coating with an nonaqueous electroless plating solution, a step of forming an electroless plating layer on the entire surface of the coating while simultaneously blackening the coating, a step of forming a mesh-like resist layer on the electroless plating layer, a step of removing portions of the electroless plating layer where no resist is present and blackened portions of the coating thereunder, and a step of optionally peeling off the resist layer.

## Description

This invention relates to a transparent electromagnetic radiation shield material for placement in front of a display device or the like to block electromagnetic radiation, and to a method of producing the material.

An electromagnetic radiation shield material for placement in front of a display device is required to have excellent transparency and wide viewing angle in addition to excellent electromagnetic radiation shielding capability. Japanese Patent Application Laid-Open Nos. 5-16281 ('281) and 10-72676 ('676) teach electromagnetic radiation shield materials meeting these requirements.

According to the invention of '281, "A transparent acrylic plate is coated with cellulose acetate propinate to form a hydrophilic transparent resin layer thereon. After being air-dried, the coated plate is soaked in hydrochloric acid palladium colloid catalyst solution to form electroless plating nuclei in the hydrophilic transparent resin, washed with water and subjected to electroless copper plating. The electroless plating is then patterned by etching by the resist method using ferric chloride. The surface of the electroless plating exhibits metallic luster while the hydrophilic transparent resin layer under the patterned electroless plating exhibits black patterning."

The invention of '676 is "A method of producing a transparent electromagnetic radiation shield material comprising the steps of applying to the surface of a transparent base material a resin solution containing a reduction metal, drying the applied solution to form a coating, optionally subjecting the coating to reduction treatment, forming an electroless plating layer on the entire surface of the coating while simultaneously blackening the coating, forming a desired resist pattern on the electroless plating layer, and removing portions of the electroless plating layer where no resist is present and blackened portions of the coating thereunder by etching, the reduction metal being a metallic salt or a metal complex or particles of a reduced metal."

However, the invention of '281 has a number of drawbacks, including:
(1) The hydrophilic transparent resin must be formed with electroless plating nuclei (catalyst) by soaking in hydrochloric acid palladium colloid catalyst solution before the electroless plating step.
(2) Since electroless plating nuclei are adsorbed on both surfaces of the substrate and both surfaces are plated by this method, the plating cost is high.
(3) In order to limit plating to only the coated surface, the opposite surface must be treated to prevent plating, which increases the number of processing steps and increases production cost.
(4) The soaking of the substrate in the catalyst solution markedly degrades adhesion between the coating and the substrate.
(5) Since the impregnation of the coating with catalyst is effected by soaking the substrate in a catalyst solution, uniform catalyst distribution in the thickness direction of the coating is hard to achieve. The blackening of the coating by plating is therefore difficult to conduct consistently and efficiently. Clarity is therefore degraded by the resulting unevenness in degree of blackness.
(6) Owing to low and uneven adhesion between the plating layer and the resin layer, the plating layer peels easily during patterning and cutting. The resulting defects (defective products) lower product yield.
(7) Owing to the use of the hydrophilic resin, durability is poor after the final processing step (formation of mesh-like plating pattern). Specifically, after durability testing (high-temperature, high-humidity, cold-hot thermal cycle) the resin layer once blackened by plating exhibits bleaching (and accompanying decrease in clarity), while plating adhesion and shielding performance are also degraded.

The invention of '676 represents a dramatic breakthrough in that it overcomes the above drawbacks (1)-(6) of '281. However, it cannot overcome the problem (7) of '281 because it requires use of a hydrophilic transparent resin in order to achieve direct aqueous electroless plating of a resin coating containing particles of a reduced metal. (However, the degree to which shielding performance, plating adherence and degree of coating blackness (clarity) are degraded is still smaller than in the case of '281.)

### SUMMARY OF THE INVENTION

The present invention, which utilizes a hydrophobic transparent resin instead of a hydrophilic transparent resin layer, provides:
(1) A transparent electromagnetic radiation shield material comprising a transparent base material, a hydrophobic transparent resin coating containing reduced metal particles (plating catalyst) laminated on the base material, and a mesh-like electroless plating layer laminated on the coating to form in the coating under the plating layer a blackened portion of mesh-like pattern identical to and aligned with that of the plating layer.
(2) The transparent electromagnetic radiation shield material of (1), wherein the hydrophobic transparent resin is one or a combination of two or more members selected from among the group consisting of hydrophobic polyvinyl acetals, polycarbonates, polycarbodiimides and polyimides.
(3) A method of producing a transparent electromagnetic radiation shield material comprising: a step of laminating a hydrophobic transparent resin coating containing reduced metal particles (plating catalyst) on a transparent base material; a step of treating the coating with an nonaqueous electroless plating solution; a step of forming an electroless plating layer on the entire surface of the coating while simultaneously blackening the coating; a step of forming a mesh-like (etching) resist layer on the electroless plating layer; a step of removing portions of the electroless plating layer where no resist is present and blackened portions of the coating- thereunder and a step of optionally peeling off the (etching) resist layer
(4) A method of producing a transparent electromagnetic radiation shield material comprising: a step of laminating a hydrophobic transparent resin coating containing reduced metal particles (plating catalyst) on a transparent base material; either (1) a step of treating the coating with an nonaqueous electroless plating solution and a step of laminating a (plating) resist layer on the treated coating in a reverse-mesh pattern or (2) a step of laminating a (plating) resist layer on the resin coating in a reverse-mesh pattern and a step of treating the coating having the (plating) resist layer laminated thereon with an nonaqueous electroless plating solution; a step of forming an electroless plating layer on the coating (at mesh-like portions where no resist is present) while simultaneously blackening the coating; and a step of optionally peeling off the (plating) resist layer.
(5) The method of (3), wherein the hydrophobic transparent resin is one or a combination of two or more members selected from among the group consisting of hydrophobic polyvinyl acetals, polycarbonate, polycarbodiimides and polyimides.
(6) The method of (4), wherein the hydrophobic transparent resin is one or a combination of two or more members selected from among the group consisting of hydrophobic polyvinyl acetals, polycarbonate, polycarbodiimides and polyimides.

### DETAILED DESCRIPTION OF THE PREFERRED EMBODIMENT

The base material used in this invention is selected with consideration to intended purpose. It is required to be transparent. It can be selected from among, for example, glass plate, plastic film, plastic sheet and plastic plate. The shape of the base material is not particularly limited.

A plastic used as the base material is preferably a resin with high transparency. Preferable examples include acrylic resins, polycarbonate, polyethylene, AS resins, vinyl acetate resin, polystyrene, polypropylene, polyester, polysulfone, polyethersulfone, polyvinylchloride, olefine-maleimide copolymer, and norbornene resins. Among these, olefine-maleimide copolymer and norbornene resins are particularly preferable owing to their high heat resistance.

The plastic should preferably have a thermal-deformation temperature of 140-360 °C, a coefficient of thermal linear expansion of not greater than 6.2x10⁻⁵cm/cm·°C, a pencil hardness of not less than 2H, a bending strength of 1,200-2,000 kgf/cm², a modulus of elasticity in bending of 30,000-50,000 kgf/cm², and a tensile strength of 700-1,200 kgf/cm². A plastic with these properties is resistant to scratching and high-temperature warping, and can therefore be used in a wide range of environments.

The plastic preferably has a light transmittance of not less than 90 %, an Abbe's number of 50-70 and a photoelasticity constant (glass region) of an absolute value of not greater than 10x10⁻¹³cm²/dyne. A plastic with these properties exhibits high transparency (is bright) and little birefringence (is not likely to produce a double image), and therefore does not degrade the image quality, brightness etc. of the display.

The resin contained in the resin solution wherein the reduced metal particles are dispersed (coating liquid) that is used to coat the base material may be of any type insofar as it exhibits the required transparency as well as good dispersibility of reduced metal particles.

For ensuring that the plating solution penetrates the resin coating dispersed with the reduced metal particles so that the reduced metal particles (plating catalyst) form nuclei and react to cause blackening by deposition of the plating metal, it is advantageous from the processing aspect to use a hydrophilic transparent resin not requiring pretreatment with a nonaqueous electroless plating solution.

However, in consideration of durability after the aforesaid final processing step (formation of mesh-like plating pattern), it is preferable to use a high-durability hydrophobic resin even if somewhat disadvantageous from the processing aspect (because it necessitates treatment with a nonaqueous electroless plating solution before aqueous plating). Preferable hydrophobic transparent resins include hydrophobic polyvinyl acetals, hydrophobic polycarbonates, hydrophobic polycarbodiimides, and hydrophobic polyimides. Among these hydrophobic polyvinyl acetals such as hydrophobic polyvinyl butyral are particularly preferable.

When the hydrophobic transparent resin referred to here is directly subjected to aqueous electroless plating in the state of a transparent resin coating containing reduced metal particles, the aqueous electroless plating solution scarcely penetrates the coating. It is thus a resin incapable of providing sufficient precipitation property and degree of coating blackness. In passing it is noted that polyvinyl acetals are available in a broad range of types ranging from, at one extreme, (water-soluble or) hydrophilic transparent resins that allow an aqueous plating solution to dissolve in the coating to some degree or allow an aqueous plating solution to penetrate the coating to a high degree to, at the other extreme, hydrophobic transparent resins that allow substantially no penetration into the coating by an aqueous plating solution without pretreatment with a nonaqueous electroless plating solution.

The reduced metal particles used in this invention are colloid particles contained in a reduced metal colloid dispersion or reduced metal powder obtained from the metal colloid dispersion. They act as plating catalyst. Insofar as they exhibit plating catalytic activity and are uniformly dispersible in the coating, they are not particularly limited as regards type of metal or grain size. They preferably have stability with respect to air and humidity. Specific examples of usable reduced metal particles include metals belonging to Group VIII of the Periodic Table of the Elements (Ni, Co, Rh, Pd etc.). Reduced Pd colloid particles and reduced Pd powder obtained therefrom are particularly preferable. The reduced metal colloid particles can be produced by the method described in Japanese Patent Application Laid-Open No. 1-315334. Specifically, a colloid dispersion can be obtained by reducing a salt or a complex of the metal in a mixed solvent consisting of a lower alcohol and an aprotic polar compound.

The resin solution containing dispersed reduced metal particles (coating liquid) is ordinarily prepared (1) by mixing a reduced metal colloid dispersion or reduced metal particles obtained by one of the above-described methods with a resin solution. It can also be prepared (2) by adding a reducing agent (e.g., sodium borohydride, lithium borohydride, dimethylaminoborane or other borohydride) in the form of powder or a solution to a solution having a metallic salt or metal complex dissolved or dispersed therein in the co-presence of part or all of the resin in the coating liquid in a dissolved state, and mixing the result. (When the coating liquid is prepared in co-presence of part of the resin, the remaining resin can be added in the form of powder or a solution after reduction.) The latter preparation method (2) generally enables a coating liquid (coating) high in plating catalytic activity to be obtained with ease. It also decreases the number of processing steps (lowers cost).

The amount of the reduced metal particles used is preferably in the range of 0.5-50PHR (parts by weight based on 100 parts of resin), more preferably 1-10PHR When the amount used is less than 0.5 PHR, the coating liquid exhibits poor plating precipitation/density property (luster). An amount exceeding 50PHR degrades the coating property. The combination of resin and reduced metal particles should also be appropriately selected with attention to these same points.

The solvent for preparing the resin solution containing dispersed reduced metal particles (coating liquid) in the present invention can be of any type insofar it can dissolve or be used to prepare a mixture or dispersion of the reduced metal particles.

Preferable solvents include one or a mixture of two or more of, for example, methanol, ethanol, chloroform, methylene chloride, trichloroethylene, tetrachloroethylene, benzene, toluene, xylene, acetone, ethyl acetate, dimethylformamide, dimethylsulfoxide, dimethylacetamide and N-methylpyrrolidone. The solvent is appropriately selected taking into account the combination of resin and reduced metal particles.

The amount of solvent used is selected so as to obtain an appropriate viscosity and fluidity and to make the solution appropriate for application to the base material.

The method of producing the transparent electromagnetic radiation shield material will now be explained.

### Step I: Formation of resin layer containing dispersed reduced metal particles

The resin solution containing dispersed reduced metal particles (coating liquid) is applied to a base material of desired configuration and dried to form a coating containing dispersed reduced metal particles. The application of the solution can be carried out by brush coating, spraying, dipping, roller coating, die coating, calender coating, spin coating, bar coating or other conventional method selected in view of the shape of the base material.

The conditions (temperature, time etc.) for coating formation are determined based on the type and concentration of the resin, the film thickness and the like. The nonvolatile content of the solution is normally 0.05-20 wt%. The coating thickness is 0.2-10 µm, preferably 0.5-5 µm.

It is also possible to form a like coating by immersing a coating composed solely of resin without dispersed reduced metal particles in a nonaqueous plating catalyst solution. As the nonaqueous plating catalyst solution there can be used the aforesaid reduced metal colloid dispersion.

### Step II: Pretreatment for aqueous electroless plating

A hydrophobic resin coating generally exhibits high resistance to penetration by a plating solution. Since an aqueous electroless plating solution can therefore not easily penetrate the coating, the plating precipitation property and degree of coating blackness after plating are poor. Because of this, aqueous electroless plating is ordinarily conducted after pretreatment with an nonaqueous electroless plating solution (washing with methanol or the like and drying for 1-30 minutes at between normal room temperature and 100 °C being carried out if required). This treatment markedly improves the initial plating precipitation property of the aqueous plating as well as the plating adherence and degree of coating blackness after aqueous plating. The reason for this is that the very high power of a nonaqueous electroless plating solution to penetrate the coating ensures high-efficiency precipitation of metal in the coating.

The treatment with the nonaqueous electroless plating solution is ordinarily conducted by immersing the coating (resin containing dispersed reduced metal particles) together with the base material on which it is formed in an nonaqueous electroless plating solution at room temperature for 1-15 minutes. However, it is also possible to spray the nonaqueous electroless plating solution onto the coating formed on the base material. This treatment is for facilitating penetration of the aqueous electroless plating solution in the next processing step and therefore need not be conducted to the point of producing metallic luster. Ordinarily the treatment is discontinued even before blackening of the coating occurs. (Although it is not unreasonable to classify the treatment of Step II as "nonaqueous plating," this step is termed as "pretreatment for aqueous plating" in the invention because the treatment is not conducted to the point of producing ordinary metallic luster.)

A nonaquecus electroless plating solution is defined as a "nonaqueous (organic solvent) solution containing at least a metallic salt or metal complex and a reducing agent." The metallic salt or metal complex is not particularly limited insofar as it is soluble in an organic solvent and can be reduced in the presence of the catalyst by a reducing agent (explained later). Specific examples include sulfates, nitrates, chlorides, organic salts (e.g, acetic acid salts), benzonitrile complexes, acetylacetonate complexes and ammonia complexes of iron, cobalt, nickel, ruthenium, rhodium, palladium, platinum, copper, silver, gold and other metals belonging to Group Ib or Group VIII of the Periodic Table of the Elements (long-period type). Among these, nickel nitrate etc. are particularly preferable.

The concentration of the metallic salt or metal complex in the nonaqueous electroless plating solution is not particularly limited insofar as it is within a range enabling dissolution of the metallic salt or metal complex in the organic solvent. Ordinarily, however, the concentration is 1-50 wt%, preferably 5-25 wt%. At a concentration exceeding 50 wt%, the metallic salt or metal complex tends to precipitate or decompose. At below 1 wt%, fluctuation in concentration becomes so great as to make continuous control difficult.

The reducing agent must be soluble in the organic solvent and capable of reducing the metallic salt or metal complex, not directly, but by catalytic action in the presence thereof. It is not particularly limited in other aspects. Specific examples include aminoborane, dimethylaminoborane and other borohydrides, ferrous salts such as FeSO₄, hydrogenphosphate metallic salts such as sodium hypophosphite, hydroxylamine sulfate, hydrosulfite and formalin. Among these, dimethylaminoborane and other borohydrides are particularly preferable.

The concentration of the reducing agent in the nonaqueous electroless plating solution is not particularly limited insofar as it is within a range enabling dissolution of the reducing agent in the organic solvent. Ordinarily, however, the concentration is 0.1-20 wt%, preferably 0.2-10 wt%. At a concentration exceeding 20 wt%, the reducing agent tends to precipitate or decompose. At below 0.1 wt%, fluctuation in concentration becomes so great as to make continuous control difficult.

The organic solvent can be of any type insofar it can dissolve the metallic salt or metal complex and the reducing agent. As a specific example, the organic solvent used to prepare the coating liquid can be utilized as is. Alcohols such as methanol and ethanol are particularly preferable.

The nonaqueous electroless plating solution is ordinarily used at a temperature of 0-50 °C, preferably 10-30 °C. At a temperature lower than 0 °C, the metal precipitation rate is impractically low. A temperature higher than 50°C is impractical because it accelerates the metal precipitation rate to the point of making control (liquid management) difficult and also promotes decomposition. The treatment period is selected as appropriate for the purpose, taking into account the metal precipitation rate.

A mesh-like plating pattern can be formed simply and with high (patterning) precision by inserting between the step of pretreatment with nonaqueous electroless plating solution and the step of aqueous electroless plating a step of forming on the coating a plating resist layer in a pattern reverse from the mesh-like plating pattern (so that only the portion where no mesh-like resist is present is plated during the aqueous electroless plating). The plating resist can be of any type or composition insofar as it is resistant to the plating solution. It can be photosensitive or non-photosensitive. When the required pattern precision is not so high, formation by printing a non-photosensitive resist is advantageous from the points of productivity and cost. The plating resist is normally removed after plating but can be allowed to remain if sufficiently transparent.

When the plating resist is resistant to the nonaqueous electroless plating solution, the order of the pretreatment with nonaqueous electroless plating solution and the formation of the plating resist pattern can be reversed.

### Step III: Aqueous electroless plating

The portion to be plated that was made receptive to plating (by imparting catalyst) in Step II, i.e., the coating on the transparent base material, is transferred to an electroless plating process to be formed with the desired metallic plating, i.e., to form a mesh-like plating pattern on the coating. The mesh-like pattern portion of the coating is simultaneously blackened (to have a black mesh-like pattern as viewed from the side of the transparent base material). The result is a transparent electromagnetic radiation shield material. The electroless plating method can be selected according to purpose from among ones in common use. Typical methods include Ni plating and Cu plating.

When it is found necessary to peel off the plating resist in Step II, this can be accomplished such as by soaking the resist portion in an aqueous alkali solution, methanol, ethanol or the like (together with shaking or exposure to ultrasonic waves) and/or spraying with a defoliating solution.

When a resist layer is not formed in Step II, etching becomes necessary because the entire surface of the coating is plated (is blackened) in Step III.

A mesh-like etching resist layer is first formed over the entire plating layer. The mesh-like etching resist can be preferably formed by a known printing method, photolithographic method or the like.

The unnecessary electroless plating layer and the unnecessary blacken portion where no resist is present is then removed by treatment with an etching solution. (The etching solution is appropriately selected for the type of metal of the electroless plating layer.) If the metal of the electroless plating layer is copper or nickel, for instance, ferric chloride or the like can be used as the etching solution.)

As a result, a blackened portion is formed in the coating under the patterned electroless plating layer in a pattern identical thereto. The portion where the electroless plating layer and the blackness are removed is transparent. The resist portion is thereafter removed by soaking it in, or spraying it with, an aqueous alkali solution or other such defoliating solution capable of dissolving the resist film.

A transparent electromagnetic radiation shield material having a mesh-like plating pattern can also be fabricated by this method.

As viewed from the side of the transparent base material (thickness: 2 mm, refractive index: 1.49, optical transmittance: 93 %, average roughness Ra: 40 Å) of the transparent electromagnetic radiation shield material, the coating preferably has a degree of blackness, expressed as optical density, of not less than 2.9 (angle of incidence of 7 °; assuming no specular component). When the optical density is less than 2.9, clarity is poor owing to the low blackness of the coating. (The intensity of plating glare increases with decreasing optical density.) When the optical density is 2.9 or greater, the blackness of the coating is adequate and clarity excellent (definition high). Clarity as perceived by the naked eye does not improve substantially above an optical density of 4.0.

The transparent electromagnetic radiation shield material preferably has an optical transmittance of not less than 65 % and a shielding performance of not less than 40 dB in the range of 30 to 1,000 MHz. An optical transmittance of less than 65% is too dark and a shielding performance of less than 40 dB does not provide a practical level of shielding.

The invention will now be explicitly explained with reference to Examples and Comparative Examples.

### Example 1.

A coating solution was prepared by mixing an n-butanol/ethanol solution of hydrophobic polyvinylbutyral (hydrophobic PVB; Denkabutyral BS-55, product of Denki Kagaku Kogyo, Co., Ltd.) containing dispersed palladium chloride (PdCl₂) with an ethanol solution of sodium borohydride (SBH) (PdCl₂ content: 1.82 PHR, hydrophobic PVB concentration: 2.8%, n-butanol/ethanol weight ratio: 77/23, SBH/ PdCl₂ mole ratio: 0.7).

The coating solution was applied to a 42-inch (980 mm x 580 mm) acrylic plate by the dip-coating method, air-dried, and then dried for 1 hr at 95 °C to form a resin coating containing Pd plating catalyst. The coating thickness was 3 µm.

The coating was pretreated by immersion for 1 min in a nonaqueous electroless plating solution (composition (weight ratio): nickel nitrate/ dimethylaminoborane/ethanol = 180/90/730) at normal room temperature.

A plating resist layer was formed on the coating in a reverse-mesh pattern by screen-printing using a plating resist ink (SP 2100 AU Clear, product of Teikoku Printing Inks Mfg. Co., Ltd.), followed by drying for 5 min at 95 °C. The result was then immersed (plated) by immersion for 15 min in a 50 °C aqueous electroless copper plating solution (OPC-Copper-H, product ofOkuno Chemical Industries Co., Ltd.). (The plating resist after plating was removed by soaking for 15 sec in methanol at normal room temperature (together with exposure to ultrasonic waves).

As a result, there was produced a transparent electromagnetic radiation shield material exhibiting copper luster at the surface of the coating on the acrylic plate and exhibiting a deep-black mesh pattern (grid of line/space = 25 µm/125 µm) at the rear surface of the coating (as viewed from the side of the acrylic plate).

The electromagnetic radiation shield material was excellent in shielding performance, optical transmittance (transparency), degree of coating blackness (clarity), plating adherence, untreated coating stability, durability (heat resistance, humidity resistance, cold-hot thermal cycle). Untreated coating stability and durability were, in particular, markedly superior to those of Comparative Example 1 set out below (fabricated according to the method of Japanese Patent Application Laid-Open No. 10-72676).

### Example 2

A transparent electromagnetic radiation shield material was fabricated under the same conditions as in Example 1, except that the copper plating was conducted without forming a plating resist layer. As a result, the entire surface of the coating on the acrylic plate exhibited copper luster and the entire rear surface of the coating exhibited a deep-black color.

The plated product was coated with an etching resist (PMER P-DF40S, product of Tokyo Ohka Kogyo Co., Ltd.), prebaked (thickness: 5 µm), exposed (using a mesh-like pattern photomask), and developed to form a mesh-like resist pattern. These processes were conducted under the conditions recommended by the manufacturer of the etching resist. The resist-patterned product was immersed in etching solution (aqueous solution of 20 % ferric chloride and 1.75 % hydrochloric acid) to remove the copper plating and the blackened copper within the coating by etching, whereafter the no longer required resist was peeled onto produce an electromagnetic radiation shield material.

The electromagnetic radiation shield material exhibited excellent performance similar to that obtained in Example 1 but was inferior to the transparent electromagnetic radiation shield material of Example 1 in patterning precision.

### Example 3

A transparent electromagnetic radiation shield material was fabricated according to the method and conditions of Example 1, except for the manner of forming the resin coating containing Pd plating catalyst (reduced metal particles). The resin coating containing Pd plating catalyst was formed not by applying and drying a coating liquid obtained by mixing a sodium borohydride solution with a PVB solution containing dispersed PdCl₂, as in Example 1, but instead by first forming a coating composed solely of hydrophobic PVB and then impregnating the resin coating with dispersed Pd colloid by immersing it in a nonaqueous Pd colloid plating catalyst solution. The Pd colloid distribution in the direction of coating thickness was not uniform as it was in Example 1 but exhibited a gradient (concentration increased with increasing proximity to the coating surface). The remaining steps in the fabrication were conducted by the same method and under the same conditions as in Example 1.

The resulting transparent electromagnetic radiation shield material was superior to that of Example 1 in plating precipitation property but was inferior thereto in plating adherence and degree of coating blackness. It was, however, markedly superior to the transparent electromagnetic radiation shield material of Comparative Example 2 (fabricated according to the method of Japanese Patent Application Laid-Open No. 5-16281) in untreated coating stability and durability.

### Example 4

A transparent electromagnetic radiation shield material (film) was fabricated in the manner of Example 1, except that the coating liquid was prepared using a chloroform solution of polycarbonate (PC) instead of the n-butanol/ethanol solution of hydrophobic PVB and using a chloroform solution of sodium borohydride instead of the ethanol solution of sodium borohydride.

The coating solution was applied to a 42-inch (980 mm x 580 mm) polyethylene terephthalate (PET) film by the roller-coating method, dried for 30 min at 60°C and then for 30 min at 80°C to form a resin coating containing Pd plating catalyst. The coating thickness was 3 µm.

The remaining steps in the fabrication were conducted by the same method and under the same conditions as in Example 1.

This transparent electromagnetic radiation shield material (film) exhibited excellent performance similar to that obtained in Example 1. Clarity was particularly good when the electromagnetic radiation shield material was laminated directly on a display panel.

### Example 5

A transparent electromagnetic radiation shield material was fabricated in the manner of Example 1, except that the coating liquid was prepared using a tetrahydrofuran solution of polycarbodiimide (PCD) (product of Nisshinbo Industries, Inc.) instead of the n-butanol/ethanol solution of hydrophobic PVB and using a tetrahydrofuran solution of sodium borohydride instead of the ethanol solution of sodium borohydride.

The coating solution was applied to a 42-inch (980 mm x 580 mm) glass plate by the die-coating method, dried for 30 min at 60 °C and then for 30 min at 180 °C to form a resin coating containing Pd plating catalyst. The coating thickness was 3 µm.

The remaining steps in the fabrication were conducted by the same method and under the same conditions as in Example 1.

This transparent electromagnetic radiation shield material exhibited excellent performance similar to that obtained in Example 1. Durability (heat resistance) was particularly outstanding.

### Example 6

A transparent electromagnetic radiation shield material was fabricated in the manner of Example 1, except that the coating liquid was prepared using a high-transparency polyimide (PI) varnish [RN-812 (N-methylpyrrolidone solution), product of Nissan Chemical Industries, Ltd.] instead of the n-butanol/ethanol solution of hydrophobic PVB and using an N-methylpyrrolidone (NMP) solution of sodium borohydride instead of the ethanol solution of sodium borohydride.

The coating solution was applied to a 42-inch (980 mm x 580 mm) glass plate by the spin-coating method, dried for 30 min at 80 °C and then for 30 min at 250 °C to form a resin coating containing Pd plating catalyst. The coating thickness was 3 µm.

The remaining steps in the fabrication were conducted by the same method and under the same conditions as in Example 1.

This transparent electromagnetic radiation shield material exhibited excellent performance similar to that obtained in Example 1. Durability (heat resistance) was particularly outstanding.

### Comparative Example 1

A coating liquid was prepared by mixing a cold aqueous solution of polyvinyl alcohol (PVA, degree of saponification: 80%) and a hydrochloric acid palladium (Pd) colloidal catalyst solution (OPC-80 Catalyst M, product of Okuno Chemical Industries Co., Ltd.). The Pd content as PdCl₂ and the resin concentration were the same as in Example 1.

The coating solution was applied to a 42-inch (980 mm x 580 mm) acrylic plate by the dip-coating method, dried for 30 min at 60 °C and then for 30 min at 95 °C to form a resin coating containing Pd plating catalyst. The coating thickness was 3 µm.

A transparent electromagnetic radiation shield material similar to that of Example 1 was fabricated by, under the same conditions as in Example 1, forming a plating resist layer on the coating, conducting electroless copper plating, and peeling off the plating resist after plating.

### Comparative Example 2

A transparent electromagnetic radiation shield material was fabricated in the manner of Comparative Example 1, except for the manner of forming the resin coating containing Pd plating catalyst. The resin coating containing Pd plating catalyst was formed not by applying and drying a coating liquid obtained by mixing an aqueous PVA solution with a Pd colloidal catalyst solution, as in Comparative Example 1, but instead by first forming a coating composed solely of PVA and then impregnating the resin coating with dispersed Pd colloid by immersing it in a hydrochloric acid Pd plating catalyst solution. The Pd colloid distribution in the direction of coating thickness was not uniform as it was in Comparative Example 1 but exhibited a gradient (concentration increased with increasing proximity to the coating surface). The remaining steps in the fabrication were conducted by the same method and under the same conditions as in Comparative Example 1.

The transparent electromagnetic radiation shield material was superior to that of Comparative Example 1 in plating precipitation property but inferior thereto in plating adherence and degree of coating blackness. It was markedly inferior to the transparent electromagnetic radiation shield material of Example 3 in untreated coating stability and durability.

### Comparative Example 3

A transparent electromagnetic radiation shield material was fabricated in the manner of Example 1, except that the pretreatment with a nonaqueous electroless plating solution was omitted. As a result, substantially no aqueous electroless plating solution penetrated the resin coating and almost no plating was precipitated.

The final products (transparent electromagnetic radiation shield materials) in Examples 1-6 and Comparative Examples 1 and 2 all exhibited substantially the same electromagnetic wave radiation shielding performance and optical transmittance.

The performance of the transparent electromagnetic radiation shield materials was evaluated as set out below. The results are shown in Table 1 and Table 2.
1) Untreated coating stability
   Rated by period usable without problem like coating immediately after formation.
   Less than 1 day (x), 1 day to less than 1 week (Δ), 1 week to less than one month
   (O), 1 month or more (ⓞ )
2) Aqueous plating precipitation property
   Rated by time to start of plating metal precipitation.
   Less than 10 sec (@), 10 sec to less than 30 sec (O), 30 sec to less than 1 min (Δ), 1 min or more (x)
3) Aqueous plating adherence
   Rated by remainder rate (%) after cross-cut tape test
   100% (ⓞ ), Not less than 90% (O), Less than 90% to not less than 10% (Δ), Less than 10% (x) '
4) Degree of coating blackness
   Rated by optical density measured using a spectrophotometric colorimeter (CMS-35SP, product of Murakami Color Research Laboratory) (optical density at angle of incidence of 7 °; assuming no specular component).
   Not less than 2.9 (ⓞ ), Less than 2.9 to not less than 2.8 (O), Less than 2.8 to not less than 2.7 (Δ), Less than 2.7 (x)
5) Durability

Shield material after durability (high-temperature, high-humidity, cold-hot thermal cycle) rated against following criteria:
ⓞ : No degradation whatsoever in any performance category (shielding performance, plating adherence, degree of coating blackness)
○ : Practically usable despite some degree of performance degradation
Δ : Not practically usable for some applications owing to performance degradation
x : Not practically usable owing to severe performance degradation

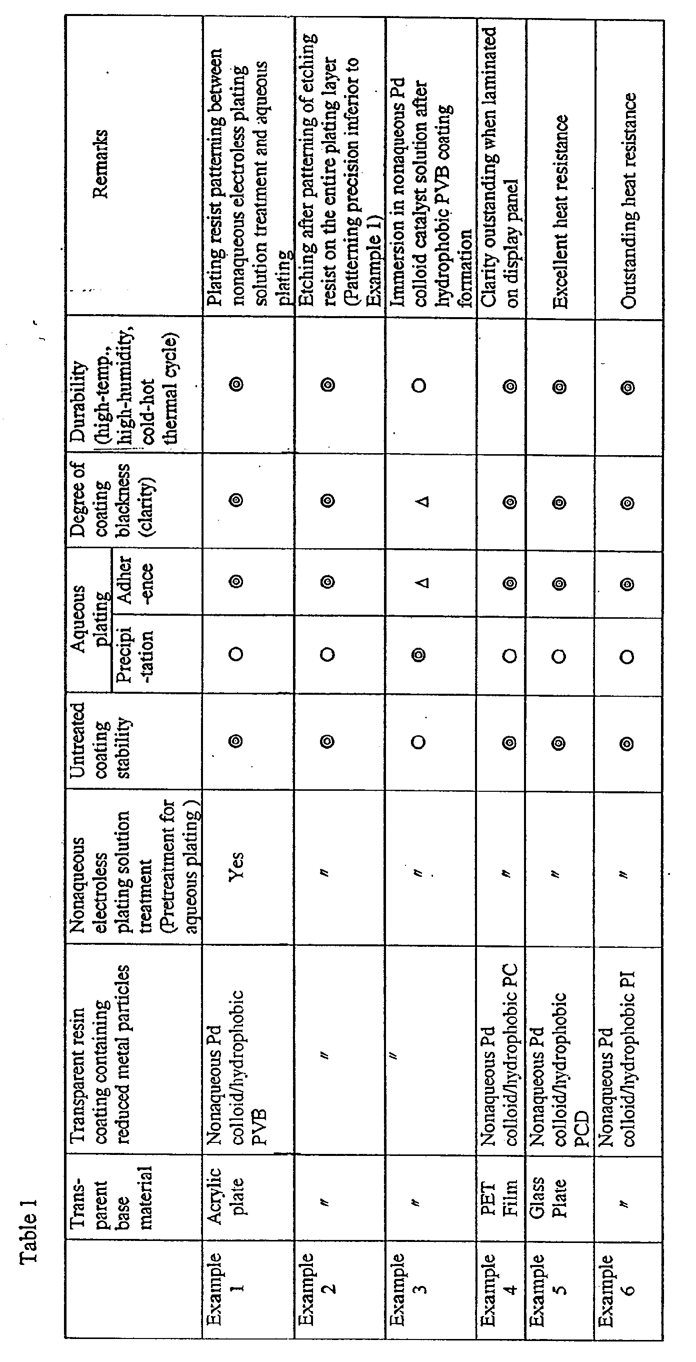

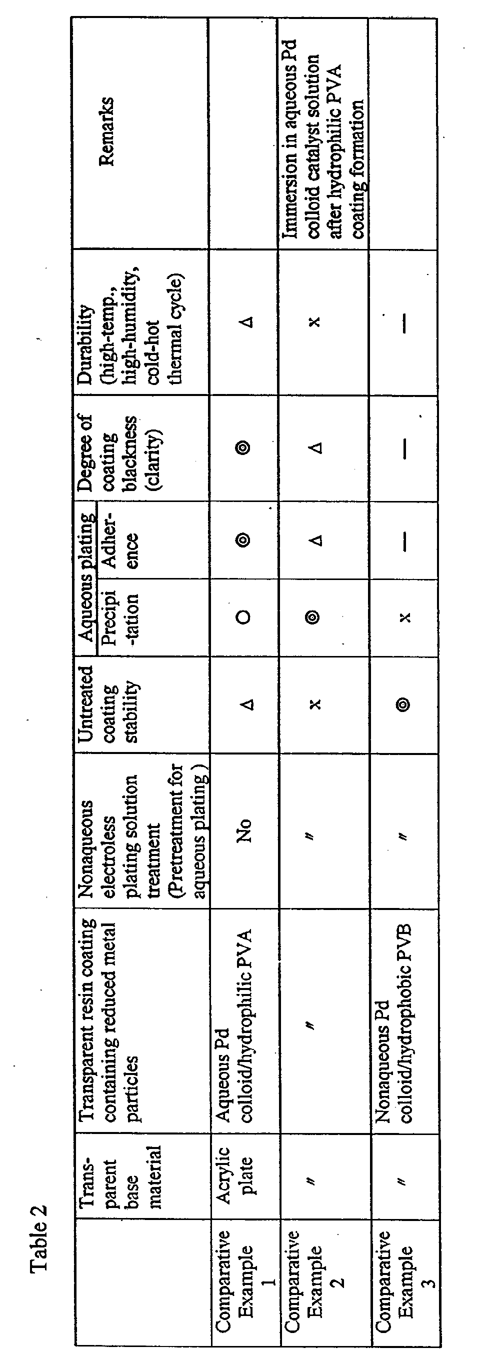

A preferred embodiment of the present invention may provide one or more of the following advantageous effects:
(1) Untreated coating (plating base) is extremely stable (owing to use of hydrophobic resin).
(2) Final product (electromagnetic radiation shield material) excellent in shielding performance, plating adherence and degree of coating blackness (clarity), and extremely high in durability (high-temperature, high-humidity, cold-hot thermal cycle).
(3) Pattern design is subject to little restriction.
(4) An earth lead can be easily connected.
(5) Black coating unnecessary.

And further (except for Example 3):
(6) Low production cost because coating formation and catalyst impartation (activation) require only a single step of forming a catalyst-containing coating.
(7) Plating cost is low because one-side plating can be achieved simply by forming the catalyst-containing coating only on one side and the pretreatment enables plating only at required portion (mesh-like pattern portion).
(8) Good coating adherence is easy to obtain owing to elimination of catalyst-imparting process (which degrades coating adherence).
(9) Uniform distribution of catalyst in coating ensures reliable precipitation of plating in coating interior and thus enables efficient blackening with minimum amount of catalyst (thus lowering catalyst cost). As this also integrates the coating and the plating metal, plating adherence is high.

The present invention thus provides numerous outstanding effects.

## Claims

1. A transparent electromagnetic radiation shield material comprising a transparent base material, a hydrophobic transparent resin coating containing reduced metal particles laminated on the base material, and a mesh-like electroless plating layer laminated on the coating to form in the coating under the plating layer a blackened portion of mesh-like pattern identical to and aligned with that of the plating layer.

2. The transparent electromagnetic radiation shield material of claim 1, wherein the hydrophobic transparent resin is one or a combination of two or more members selected from among the group consisting of hydrophobic polyvinyl acetals, polycarbonates, polycarbodiimides and polyimides.

3. A method of producing a transparent electromagnetic radiation shield material comprising:
a step of laminating a hydrophobic transparent resin coating containing reduced metal particles on a transparent base material;
a step of treating the coating with an nonaqueous electroless plating solution;
a step of forming an electroless plating layer on the entire surface of the coating while simultaneously blackening the coating;
a step of forming a mesh-like resist layer on the electroless plating layer;
a step of removing portions of the electroless plating layer where no resist is present and blackened portions of the coating thereunder; and
a step of optionally peeling off the resist layer.

4. A method of producing a transparent electromagnetic radiation shield material comprising:
a step of laminating a hydrophobic transparent resin coating containing reduced metal particles on a transparent base material;
either (1) a step of treating the coating with an nonaqueous electroless plating solution and a step of laminating a plating resist layer on the treated coating in a reverse-mesh pattern or (2) a step of laminating a plating resist layer on the resin coating in a reverse-mesh pattern and a step of treating the coating having the resist layer laminated thereon with an nonaqueous electroless plating solution;
a step of forming an electroless plating layer on the coating (at mesh-like portions where no resist is present) while simultaneously blackening the coating; and
a step of optionally peeling off the plating resist layer.

5. The method of claim 3, wherein the hydrophobic transparent resin is one or a combination of two or more members selected from among the group consisting of hydrophobic polyvinyl acetals, polycarbonate, polycarbodiimides and polyimides.

6. The method of claim 4, wherein the hydrophobic transparent resin is one or a combination of two or more members selected from among the group consisting of hydrophobic polyvinyl acetals, polycarbonates, polycarbodiimides and polyimides.

7. A transparent electromagnetic radiation shield material comprising a transparent base material, a mesh-like pattern of a blackened hydrophobic transparent resin coating containing reduced metal particles laminated on the base material, and a mesh-like electroless plating layer of mesh-like pattern identical to and aligned with that of the blackened resin coating, said plating layer being laminated on the coating.

8. The transparent electromagnetic radiation shield material of claim 7, wherein the hydrophobic transparent resin is one or a combination of two or more members selected from among the group consisting of hydrophobic polyvinyl acetals, polycarbonates, polycarbodiimides and polyimides.
